# EUROPÄISCHE PATENTANMELDUNG

(11) **EP 1 720 387 A1**
(43) Veröffentlichungstag der Anmeldung: **08.11.2006**
(21) Anmeldenummer: 05009661.9
(22) Anmeldetag: 03.05.2005
(51) Int. Cl.: H05K 3/30, H01R 12/34

(54) **Hochstromkontakt in massiver Einpresstechnik**

(71) Anmelder: Broch, Franz, 25123 Brescia (IT)
(72) Erfinder: Broch, Franz, 25123 Brescia (IT)

(57) **Zusammenfassung**

Kontaktelement mit einer massiven Einpresszone, die so ausgebildet ist, dass die gesamte metallisierte Huelse der Durchkontaktierung einer Leiterplatte als Kontaktfiaeche verwendet wird und somit die Uebertragung hoher elektrischer Stroeme auf eine Leiterplatte ermoeglicht. Das Kontaktelement dient zur Anbindung von Verdrahtungen, Steckerelementen oder mechanischen Bauelementen an Leiterplatten oder andere Bauelemente.

## Beschreibung

Die Erfindung bezieht sich auf die Stromeinspeisung von Leiterplatten und Stromschienen und insbesonders auf eine loetfreie Anschlussmoeglichkeit von Stromzuleitungen mit grossem Leiterquerschnitt.

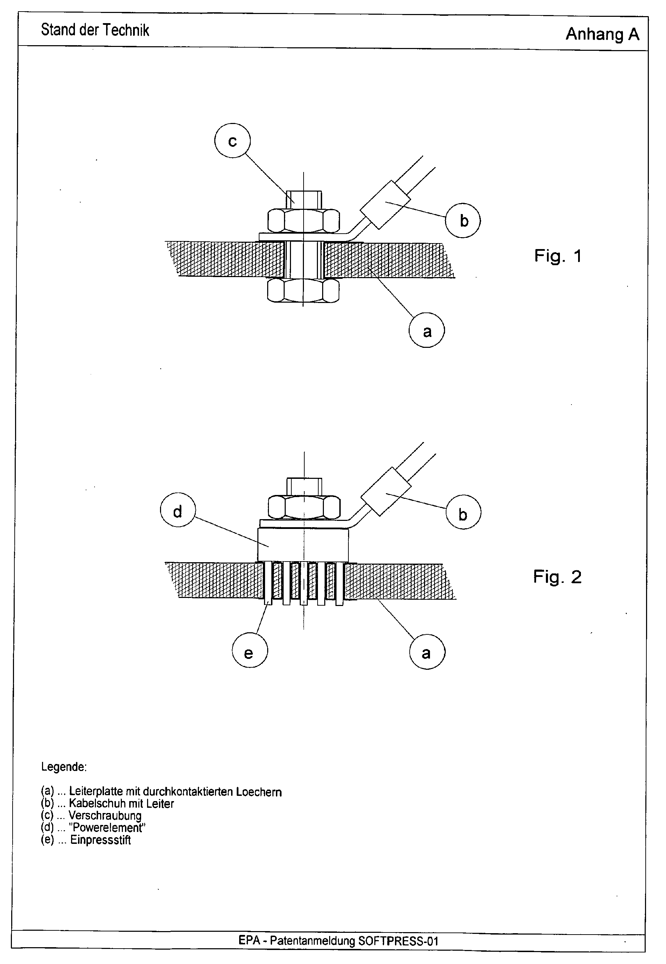

Da es schwierig und daher technisch nicht sinnvoll ist, Stromzuleitungen mit grossem Querschnitt direkt in Leiterplatten oder Stromschienen einzuloeten, wird diese Kontaktierung normalerweise mittels einer Schraubverbindung hergestellt (Fig. 1). Dabei wird der meist ein mit einem Kabelschuh (b) versehener Anschlussdraht mittels einer Schraubverbindung (c), die durch das durchkontaktierte Loch einer Leiterplatte (a) oder durch die Bohrung einer Stromschiene geht, mit der Leiterplatte bzw. Stromschiene in Verbindung gebracht und somit der elektrische Kontakt hergestellt.

Der Vorteil dieser Art der Verbindung einer Stromzuleitung auf eine Leiterplatte besteht darin, dass sie sehr kostenguenstig ist.

Nachteilig ist hingegen, dass diese Art der Verbindung langfristig nicht sicher und konstant ist. Dies begruendet sich aus den physikalischen Eigenschaften einer Leiterplatte, die aus mit Glasfasern verstaerktem Kunstharz besteht, welches langfristig unter dem Druck der Verschraubung nachgibt und somit nicht formstabil bleibt. Dadurch vermindert sich der Anpressdruck der Schraubverbindung, was infolgedessen zu einer Erhoehung des Uebergangswiderstandes zwischen Leiterplatte und Kabelschuh bzw. Stromschiene fuehrt. Diese Erhoehung des Uebergangswiderstandes bewirkt laut Ohm'schem Gesetz eine dem Widerstand proportionale Waermeenergie, welche auf Grund chemischer Reaktionen zu einer weiteren Widerstandserhoehung und somit Temperaturerhoehung fuehrt, was schlussendlich die Zerstoerung der Leiterplatte zur Folge hat.

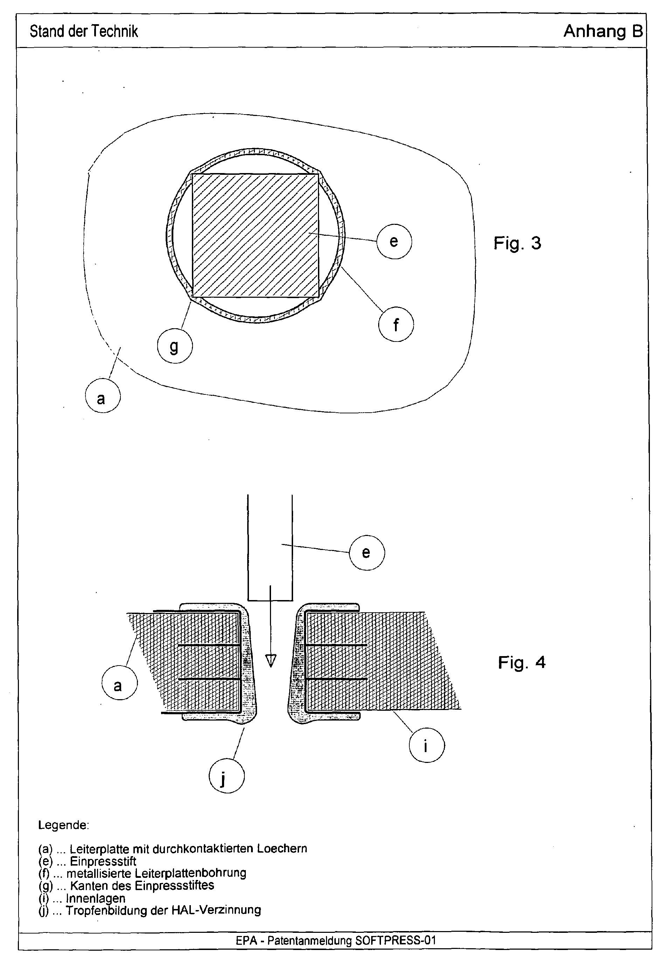

Auf Grund dieser nachteiligen Eigenschaften sind am Markt Kontaktelemente erhaeltlich, die sich der sogenannten und in der Norm "DIN EN 60352-5" beschriebenen "massiven (starren) Einpresstechnik" bedienen. Solche Kontaktelemente werden im Internet unter www.we-online.de als "Powerelemente" beschrieben. Diese "Powerelemente" stellen an Stelle der oben beschriebenen Schraubverbindung die Verbindung zwischen dem Kabelschuh und der Leiterplatte her. Wie in Fig. 2 dargestellt, werden diese "Powerelemente" (d), welche mit vierkantigen Stiften (e) versehen sind, in die durchkontaktierten Bohrungen der Leiterplatte (a) eingepresst. Da die Diagonale der vierkantigen Einpressstifte (e) groesser als der Innendurchmesser der metallisierten Leiterplattenbohrung (f) ist (siehe Fig. 3), verformt sich diese Bohrung durch den Einpressdruck an den vier Kanten (g) und stellt somit in diesem Bereich die elektrische Verbindung zwischen Leiterplatte und "Powerelement" dauerhaft her.

Nachteilig bei dieser Art der Einpressung ist, dass wie erwaehnt, die Einpressstifte nur an den Kanten die elektrische Verbindung herstellen und somit, wie dies aus Schliffbildern ersichtlich ist, nur 10% - 20% der Metallhuelse der Leiterplattenbohrung zur Stromuebertragung herangezogen werden. Dadurch ist die Uebertragung der Stromstaerke erheblich begrenzt. Um der notwendigen Stromuebertragung einigermassen gerecht zu werden, muessen pro "Powerelement" mehrere Einpressstifte zur Anwendung kommen. In der Praxis sind das etwa 16 Stifte pro Quadratzentimeter Leiterplattenflaeche, die in einem Gittermuster angebracht werden. Diese grosse Anzahl der Stifte begrenzt automatisch den zur Verfuegung stehenden Platz fuer den Lochdurchmesser. Da dadurch der Lochdurchmesser kleiner als die Leiterplatte dick ist, wird bei der zur Anwendung kommenden HAL-Verzinnung (Hot Air Levelling = Heissluftverzinnung), bei welcher die fluessige Zinnlegierung mittels heisser Luft durch das Loch geblasen wird, der Luftfluss so stark behindert, dass es, wie in Fig. 4 dargestellt, zur Tropfenbildung (j) an der Ausblasseite fuehren kann. Dieser unerwuenschte Effekt verstaerkt sich besonders dann, wenn die Innenlagen (i) der Mehrlagenleiterplatte grosse Kupferdicken aufweisen, die durch ihre thermische Traegheit wie Kuehlkoerper agieren und daher die durchgeblasene Zinnlegierung schneller abkuehlt und somit die Tropfenbildung derart verstaerkt wird, dass die Gefahr der Verstopfung der Bohrung besteht. Die Verengung der Bohrung fuehrt in jedem Fall zur Erhoehung des Einpressdruckes, wodurch beim Einpressen der Stifte (e) die metallisierte Huelse in der Bohrung ueberbeansprucht wird, was zur Auspressung oder zumindest zur Beschaedigung fuehren kann, was einer Zerstoerung der Leiterplatte gleich kommt. Weiters ist nachteilig bei der Verwendung von mehreren Einpressstiften pro "Powerelement", die durch Fraesungen herausgearbeitet werden, dass deren Toleranz, sowohl bezueglich deren Diagonale als auch deren Position, auf einige Hundertstel mm begrenzt ist, da sonst die Gefahr der oben erwaehnten Auspressung besteht.

Ziel der vorliegenden Erfindung ist es, ein Kontaktelement herzustellen, das all die oben erwaehnten Nachteile behebt und somit wirtschaftlich sinnvoll fuer eine Massenproduktion anwendbar ist.

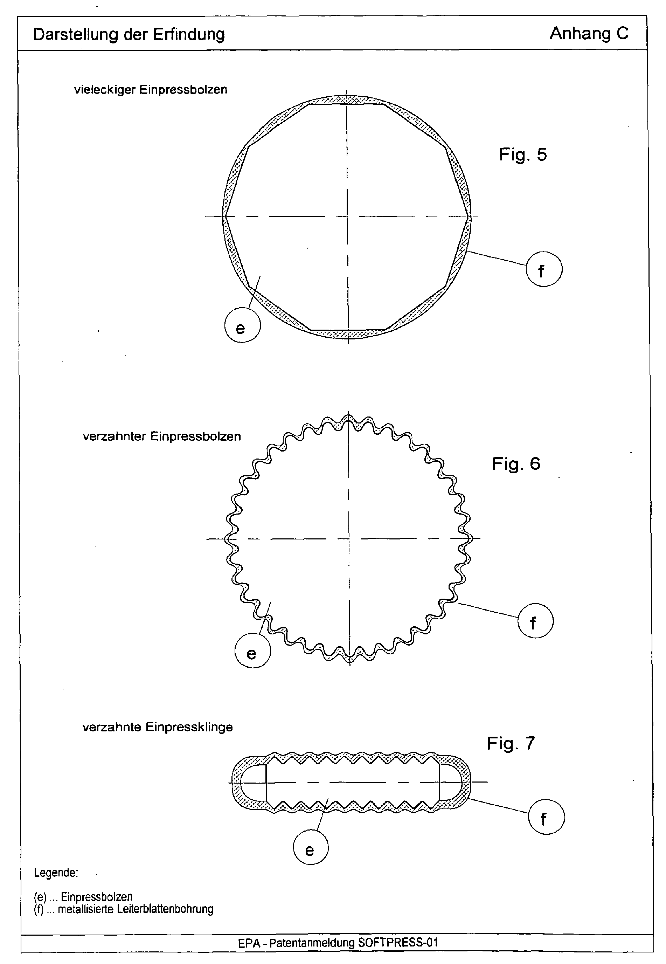

Wenn nicht vierkantige Einpressstifte, sondern entsprechend vieleckige Bolzen (siehe Fig. 5) verwendet werden, dann verformt sich die metallisierte Bohrung in der Leiterplatte derart, dass der gesamte Mantel des zylindrischen Loches als Kontaktflaeche dient. Das bedeutet dass 100% der gesamt moeglichen Kontaktflaeche zur Stromuebertragung zur Verfuegung steht und nicht nur 10 bis 20%, wie dies bei vierkantigen Stiften der Fall ist.

Eine weitere Vergroesserung der Kontaktflaeche zwischen Bolzen und der metallisierten Huelse der Leiterplattenbohrung erzielt man, wenn an Stelle des vieleckigen Einpressbolzens ein Bolzen mit einer Verzahnung an der Einpresszone (siehe Fig. 6) verwendet wird. Durch diese Formgebung der Einpresszone verdoppelt sich die Kontaktflaeche nochmals, wie dies aus Schliffbildern leicht erkennbar ist.

Da die Einpressbolzen einen wesentlich groesseren Durchmesser als die vierkantigen Einpressstifte haben, treten die oben erwaehnten Probleme bei der HAL-Verzinnung, die durch einen zu kleinen Durchmesser hervorgerufen werden, nicht mehr auf, da die durch die Bohrung stroemende Luft-Zinn-Menge wesentlich groesser ist.

Analog zu der oben erwaehnten zirkularen Einpresszone (Bohrung in Leiterplatte) kann die beschriebene Verzahnung auch auf einer linearen Flaeche (z.B. Blech) aufgebracht werden (Fig. 7), was sinnvoll ist, wenn statt Bohrungen Langloecher (Schlitze) in die Leiterplatte gefraest oder gestanzt werden. Eine typische Verwendung dafuer sind Strombuegel oder gestanzte Kontaktelemente.

Die in dieser Erfindung dargestellten Einpresszonen besitzen einen derart kleinen Uebergangswiderstand zwischen Kontaktelement und Leiterplatte, dass dieser mit herkoemmlichen Mitteln nicht mehr messbar ist. Das bedeutet, dass die maximale Stromuebertragung nicht mehr von der Einpresszone abhaengig ist, sondern nur noch von der Zuleitung oder den Leiterbahnen auf der Leiterplatte.

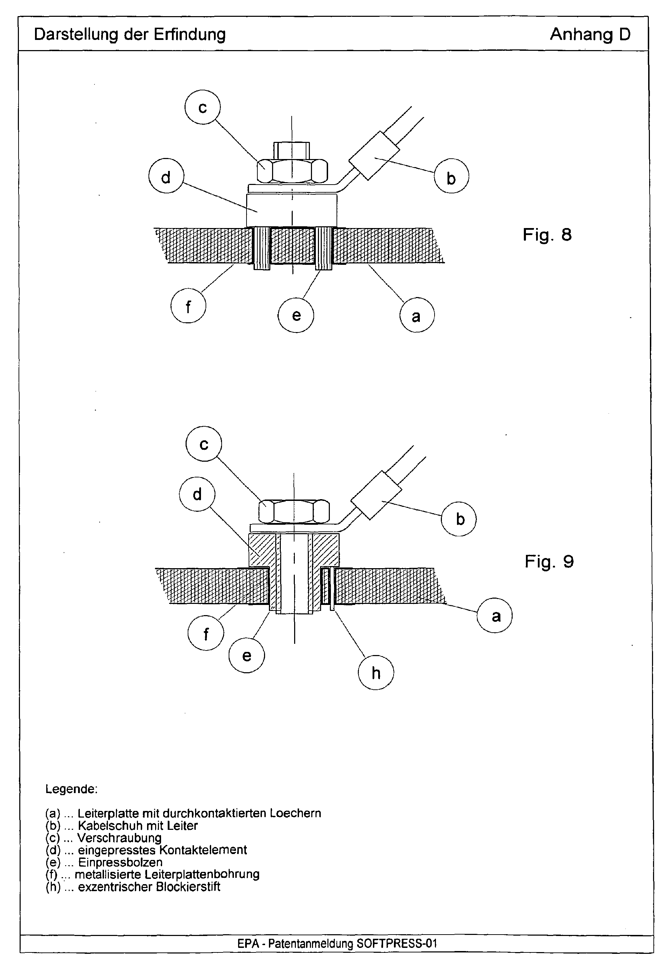

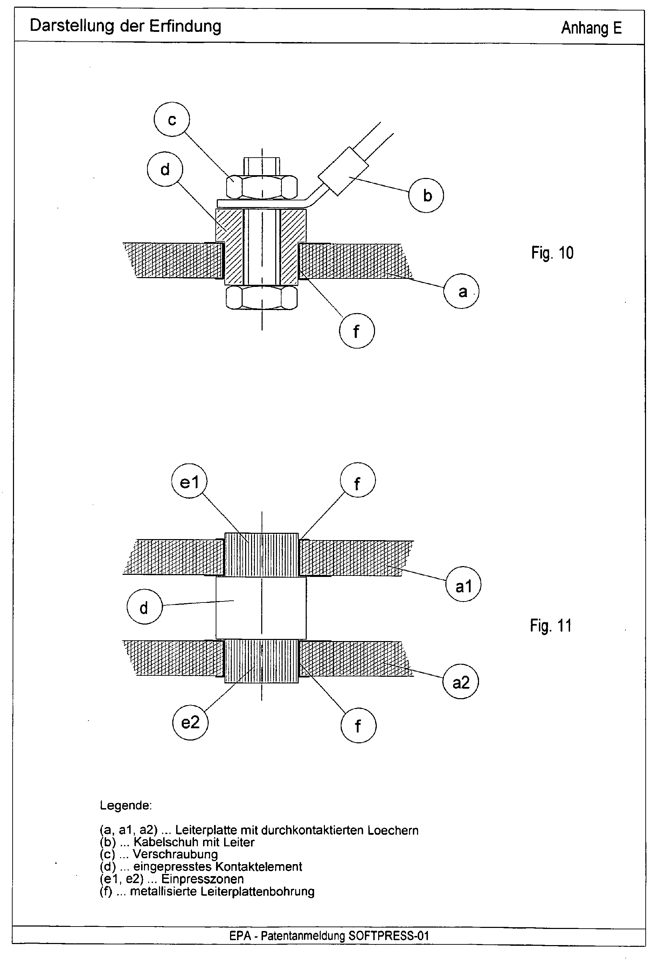

Die Anbindung der Stromschiene oder des Kabelschuhs (b) an das Kontaktelement (d) erfolgt entweder, wie in Fig. 10 dargestellt, mit einer Schraube und Mutter (c). Alternativ kann ein Kontaktelement verwendet werden, welches mit einem Gewindebolzen (siehe Fig. 8) oder mit einem Innengewinde (siehe Fig. 9) versehen ist, das zur Befestigung des Kabelschuhs (b) oder anderer Elemente dient.

Um zu verhindern, dass das Anzugsdrehmoment der Verschraubung zum Ausreissen der Einpresszone fuehrt, muessen entweder die Einpressbolzen (e) exzentrisch zur Schraubenachse angeordnet (siehe Fig. 8), oder, bei einem konzentrischen Einpressbolzen, muss ein Blockierstift (h) exzentrisch angebracht werden (siehe Fig. 9).

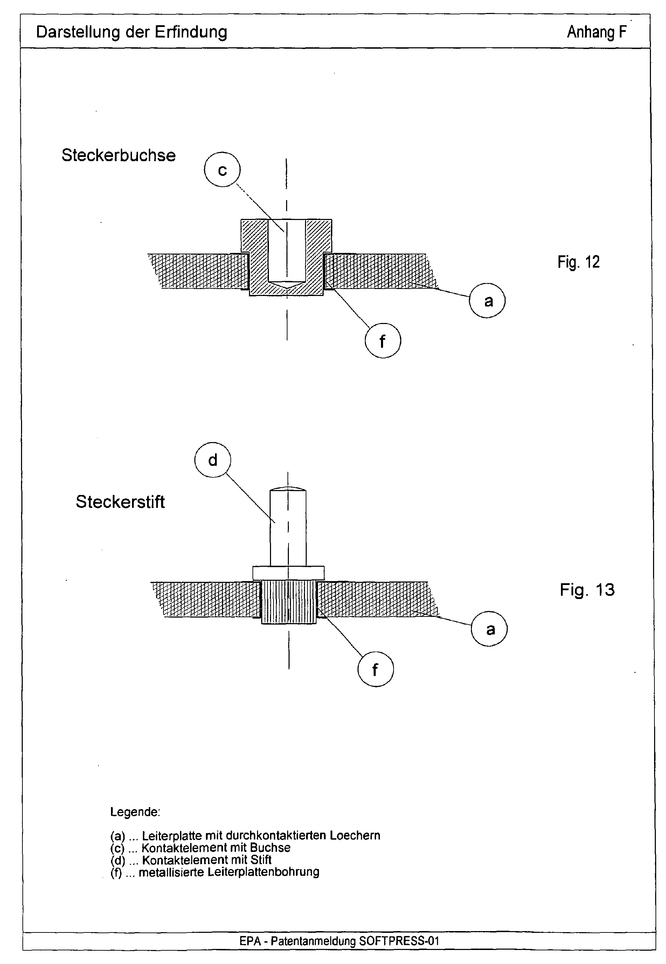

Um den Strom von der Leiterplatte (a2) auf eine Stromschiene, bzw. von einer Leiterplatte auf eine darueberliegende Leiterplatte (a1) im "Huckepack"-Verfahren zu uebertragen, koennen die Kontaktelemente (d) mit zwei Einpresszonen (e1, e2) versehen werden, wie dies in Fig. 11 dargestellt wird.

Die Kontaktelemente koennen auch so bearbeitet werden, dass sie als Buchse (c) (Fig. 12) oder als Stift (d) (Fig. 13) fuer eine Steckverbindung verwendet werden koennen.

## Patentansprüche

1. Kontaktelement, das mit einer massiven Einpresszone versehen ist, welche die gesamte Oberflaeche der metallisierten Huelse eines Bohrloches einer Leiterplatte als Kontaktflaeche verwendet. Diese Einpresszone kann entweder die Form eines Polygons (Fig. 5) oder die einer Verzahnung (Fig. 6) aufweisen. Durch diese Art der Formgebung der Einpresszone passt sich der Einpressbolzen vollkommen dem metallisierten Loch der Leiterplatte bzw. der Bohrung in einer Stromschiene an.

2. Kontaktelement nach Anspruch 1, wobei die Einpresszone nicht zirkular ausgebildet ist (Fig. 6), sondern linear auf einer geraden Flaeche (Fig. 7), um dieses so geformte Kontaktelement in ein Langloch (Schlitz) einpressen zu koennen.

3. Kontaktelement nach Anspruch 1, wobei eine am Kontaktelement entsprechend angebrachte Bohrung (Fig. 10) bzw. ein Aussen- oder Innengewinde (Fig. 8 und 9) dazu dienen, dass Kabelverbindungen, Stromschienen oder andere Bauteile befestigt werden koennen.

4. Kontaktelement nach Anspruch 3, wobei durch das exzentrische Anbringen von mindestens zwei Einpressbolzen (e) (Fig. 8) oder eines Blockierstiftes (h) (Fig. 9) verhindert wird, dass durch das Anzugsdrehmoment der Verschraubung die Einpresszone durch Rotation ausreisst.

5. Kontaktelement nach Anspruch 1, wobei eine am Kontaktelement angebrachte Buchse (c) (Fig. 12) oder ein Stift (d) (Fig. 13) die Funktion einer Steckverbindung uebernimmt.
